# EUROPÄISCHE PATENTANMELDUNG

(11) **EP 1 455 450 A2**
(43) Veröffentlichungstag der Anmeldung: **08.09.2004**
(21) Anmeldenummer: 04004871.2
(22) Anmeldetag: 02.03.2004
(51) Int. Cl.: H03J 1/00

(54) **Dynamische Ländererkennung**

(30) Priorität: 03.03.2003 DE 10309182
(71) Anmelder: Harman Becker Automotive Systems GmbH, 76307 Karlsbad (DE)
(72) Erfinder: Körner, Andreas, 76337 Waldbronn (DE); Benz, Christoph, 77797 Ohlsbach (DE); Gierl, Stefan, 76133 Karlsruhe (DE)
(74) Vertreter: Grünecker, Kinkeldey, Stockmair & Schwanhäusser Anwaltssozietät

(57) **Zusammenfassung**

Die vorliegende Erfindung bezieht sich auf Verfahren zur Konfiguration eines mobilen Rundfunkempfängers, der mit einer positionsbestimmenden Einheit verbindbar ist. Weiterhin bezieht sich die vorliegende Erfindung auf den mobilen Rundfunkempfänger selbst. Um die Konfiguration des Ländercodes in einem Rundfunkempfänger zu vereinfachen und unabhängig vom Produktionsprozess zu ermöglichen nutzt die Erfindung die Positionsdaten eines GPS-Empfänger um dynamisch die Region zu bestimmen, in der sich das Rundfunkgerät bzw. das Fahrzeug gerade befindet. Sollte sich die erkannte Region von der im Empfänger eingestellten Region unterscheiden, so kann die neue Region von dem Rundfunkempfänger erkannt werden indem ein GPS-Empfänger die aktuellen Positionsdaten des Rundfunkempfängers (oder des Fahrzeuges) zur Verfügung stellt und basierend auf den Positionsdaten die neue Region ermittelt und als aktualisierte Standardeinstellung in den Speicher des Rundfunkgerätes übernommen wird.

## Beschreibung

Die vorliegende Erfindung bezieht sich auf Verfahren zur Konfiguration eines mobilen Rundfunkempfängers, der mit einer positionsbestimmenden Einheit verbindbar ist. Weiterhin bezieht sich die vorliegende Erfindung auf den mobilen Rundfunkempfänger selbst.

Die verschiedenen Betriebsparameter eines Rundfunkempfängers hängen von der geografischen Position, an der der Rundfunkempfänger benutzt wird, ab. Um die jeweilige Region und somit die Betriebsparameter des Rundfunkempfängers zu bestimmen, wird in der Fertigung für die entsprechende Region, in welcher der Rundfunkempfänger eingesetzt werden soll, ein Ländercode vergeben, der in einem Speicher abgespeichert wird. Entsprechend dieses Ländercodes werden die Betriebsparameter des Rundfunkempfängers eingestellt.

Insbesondere sind große Unterschiede in den Betriebsparametern zwischen den USA, Japan und Europa von Bedeutung, auf die sich ein mobiler Rundfunkempfänger einstellen lassen muss. Beispielsweise unterscheiden sich die Bandgrenzen für den FM- und AM-Empfang zwischen Europa und den USA, ebenso wie der Abstand zwischen den einzelnen Rundfunksendern in diesen Regionen. Ein weiteres Beispiel ist die FM-Entzerrung und die AM-Bandbreite, die von geografischer Region zu Region unterschiedlich ist. Weitere Beispiele für die Unterschiede sind die verschiedenen Frequenzobergrenzen für das mittlere AM-Wellenband in den USA mit 1710 kHz, in Japan mit 1629 kHz und Europa mit 1620 kHz.

In den meisten Regionen der Erde erstreckt sich das FM-Frequenzband zwischen 87,5 MHz und 108,0 MHz. In Japan beträgt die untere Frequenzgrenze jedoch 76,0 MHz und die obere Grenze 90,0 MHz. Weiterhin ist beispielsweise in den USA der Abstand zwischen den einzelnen FM-Sendern 200 kHz, während in der restlichen Welt 100 kHz Senderabstand vorzufinden ist.

Auch beim Empfang von Femsehsignalen entsprechend der verschiedenen Standards PAL, NTSC und SECAM benötigt ein Empfänger eine entsprechende Einstellung seiner Betriebsparameter zum Empfang der Fernsehsignale, die je nach System und Region unterschiedlich sind.

Dementsprechend ist es notwendig, dass ein Mikroprozessor in einem Rundfunkempfänger in Abhängigkeit von der Region den Rundfunkempfänger entsprechend parametrieren kann, um einen Senderempfang zu ermöglichen.

Das Speichern von Ländercodes während der Fertigung eines Rundfunkempfängers auf nichtflüchtigen Speichern, wie z.B. einem EEPROM, hat vielerlei Nachteile. Beispielsweise benötigt das Speichern des Ländercodes im Speicher einen eigenen Programmierschritt der entsprechend der geografischen Lage des Marktes, für den der Verkauf der produzierten Rundfunkgeräte geplant ist, angepasst werden muss. Dieser Programmierschritt erschwert darüber hinaus den Produktionsprozess, da Verkaufskapazitäten vor der Produktion der Rundfunkempfänger bekannt sein müssen, um so eine genügende Anzahl von Empfängern mit dem entsprechenden Ländercode zu versehen.

Fehlkalkulationen in den Absatzchargen bedingen daher auch einen großen finanziellen Aufwand, wenn bereits mit einem Ländercode programmierte Rundfunkempfänger noch einmal in einem Extraverfahren auf einen neuen Absatzmarkt hin überarbeitet werden müssen, d.h. ihr Ländercode neu programmiert werden muss.

Die Aufgabe der vorliegenden Erfindung ist es daher, die Konfiguration des Ländercodes zu vereinfachen und unabhängig vom Produktionsprozess zu ermöglichen.

Die vorliegende Erfindung basiert auf der Idee, dass in nahezu allen Fahrzeugen mit mobilen Rundfunkempfängern GPS-Empfänger eingebaut werden. Dadurch ist es möglich, dynamisch die Region zu bestimmen, in der sich das Rundfunkgerät bzw. das Fahrzeug gerade befindet. Sollte sich die erkannte Region von der eingestellten Region unterscheiden, so kann die neue Region von dem Rundfunkempfänger erkannt werden indem ein GPS-Empfänger die aktuellen Positionsdaten des Rundfunkempfängers (oder des Fahrzeuges) zur Verfügung stellt und basierend auf den Positionsdaten die neue Region ermittelt und als aktualisierte Standardeinstellung in den Speicher des Rundfunkgerätes übernommen wird. Insbesondere ist so auch eine Initialisierung, d.h. eine automatische Einstellung des Ländercodes, bei der ersten Inbetriebnahme des Rundfunkempfängers möglich, was die feste Programmierung eines Ländercodes im Produktionsprozess unnötig macht.

Die vorliegende Erfindung gibt ein Verfahren zur Konfiguration eines mobilen Rundfunkempfängers, der mit einer positionsbestimmenden Einheit verbindbar ist, an. Das erfindungsgemäße Verfahren bestimmt dabei zuerst die Positionsdaten des Rundfunkempfängers durch eine positionsbestimmende Einheit, wie z.B. ein Navigationsgerät mit GPS-Empfänger oder einem GPS-Empfänger selbst. Die positionsbestimmende Einheit leitet die Positionsdaten entweder an den Rundfunkempfänger weiter, der die bestimmten Positionsdaten empfängt und einen Ländercode basierend auf den empfangenden Positionsdaten bestimmt. Alternativ bestimmt die positionsbestimmende Einheit den Ländercode und leitet ihn an den Rundfunkempfänger weiter. Schließlich wird der Ländercode in einem Speicher im Rundfunkempfänger nichtflüchtig abgespeichert.

Weiter ist es von Vorteil, wenn die Betriebsparameter des Rundfunkempfängers anhand des Ländercodes eingestellt werden.

In einer Weiterbildung des Rundfunkempfängers können die Positionsdaten durch den Rundfunkempfänger angefordert werden. Alternativ fordert der Rundfunkempfänger den Ländercode von der positionsbestimmenden Einheit an, falls diese ihn bestimmt.

In einer bevorzugten Ausführungsform handelt es sich bei dem Speicher im Rundfunkempfänger um ein EEPROM.

Weiterhin ist es möglich, die Positionsdaten oder alternativ den Ländercode während der Initialisierung des Rundfunkempfängers von der positionsbestimmenden Einheit anzufordern, was insbesondere eine feste Programmierung des Ländercodes im Fertigungsprozess des Rundfunkempfängers überflüssig macht.

Bei den Betriebsparametem, die anhand des Ländercodes eingestellt werden können, handelt es sich beispielsweise um die Bandgrenzen der AM-Bänder, die Bandgrenzen der FM-Bänder, dem Frequenzabstand zwischen zwei Rundfunksendern, die AM-Bandbreite oder die FM-Nachentzerrung.

Beim Empfang von Fernsehsignalen, umfassen die einzustellenden Betriebsparameter die notwendigen Parameter zur Wiedergabe der Femsehsignale entsprechend dem PAL, SECAM und/oder NTSC System.

Weiterhin wird ein mobiler Rundfunkempfänger angegeben, der mit einer positionsbestimmenden Einheit verbindbar ist. Der Rundfunkempfänger beinhaltet dabei eine Kommunikationseinheit zum Empfangen der Positionsdaten oder eines Ländercodes, die/der von der positionsbestimmenden Einheit ermittelt wurde/n, einen Mikroprozessor zum Bestimmen eines Ländercodes basierend auf den empfangenen Positionsdaten und einen Speicher zur nichtflüchtigen Speicherung des Ländercodes in dem Rundfunkempfänger. Alternativ kann der Ländercode auch in der positionsbestimmenden Einheit ermittelt werden und an der Rundfunkempfänger übergeben werden.

Weiterhin ist es von Vorteil, wenn der Mikroprozessor die Betriebsparameter des Rundfunkempfängers anhand des Ländercodes einstellt.

Weiterhin ist die Kommunikationseinheit so ausgebildet, dass sie die Positionsdaten oder einen Ländercode von der positionsbestimmenden Einheit anfordern kann. Dies kann insbesondere in einer Initialisierungsphase des Rundfunkempfängers geschehen, in der der Mikroprozessor die Positionsdaten mittels der Kommunikationseinheit zur Initialisierung des Rundfunkempfängers anfordert.

Die vorliegende Erfindung ist in einem Rundfunkempfänger für Femsehsignale und/oder in einem Rundfunkempfänger für Radioprogramme vorteilhaft einsetzbar.

Anhand der in den beiliegenden Figuren dargestellten bevorzugten Ausführungsformen wird die Erfindung im Folgenden näher erläutert. Ähnliche oder korespendierende Einzelheiten sind in den Figuren mit den gleichen Bezugszeichen versehen.
- **Fig. 1**: zeigt einen schematischen Aufbau einer Ausführungsform eines Rundfunkempfängers, der mit einer positionsbestimmenden Einheit verbunden ist und
- **Fig. 2**: zeigt einen schematischen Aufbau einer zweiten Ausführungsform eines Rundfunkempfängers, der mit einer positionsbestimmenden Einheit verbunden ist.

Für ein Rundfunkempfängersystem existieren weltweit eine Reihe von unterschiedlichen Anforderungen an die Software, die vom Mikroprozessor ausgeführt wird, in Abhängigkeit der Region, in welcher der Rundfunkempfänger eingesetzt werden soll. Insbesondere unterscheiden sich zwischen Europa, USA und Japan verschiedene Betriebsparameter, so dass der Rundfunkempfänger entsprechend der Region, in der er eingesetzt wird, parametrisiert werden muss.

Beispielsweise unterscheiden sich die Bandgrenzen des AM-Bandes, des FM-Bandes, der Frequenzabstand zwischen benachbarten Rundfunksendern, die AM-Bandbreite sowie die FM-Nachentzerrung (FM De-emphasis) in den verschiedenen Regionen. Da heute in nahezu allen Systemen im Fahrzeug GPS-Empfänger integriert werden, ist es möglich, dynamisch die Region zu bestimmen, in der sich ein Rundfunkempfänger gerade befindet. Die Kommunikation zwischen Rundfunkempfänger und GPS-Empfänger ermöglicht es, dass der Rundfunkempfänger durch das GPS-Gerät jederzeit von der momentanen Position des mobilen Rundfunkempfängers informiert werden kann, d.h. Positionsdaten vom GPS-Empfänger über ein Fahrzeug-Bordnetz oder ein Bussystem empfangen kann.

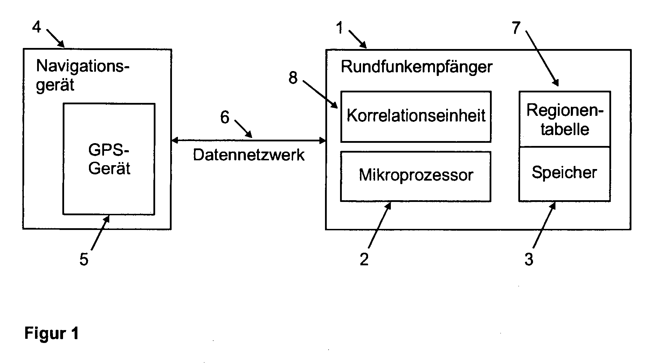

Fig. 1 zeigt erläuternd eine schematische Darstellung eines Rundfunkempfängers 1, der mit einem GPS-Gerät 5 über ein Datennetzwerk 6 gekoppelt ist. In der dargestellten bevorzugten Ausführungsform beinhaltet ein Navigationsgerät 4 den GPS-Empfänger 5.

Der Rundfunkempfänger 1 besitzt einen Mikroprozessor 2 sowie einen nichtflüchtigen Speicher 3, beispielsweise in Form eines EEPROMs. Der Speicher 3 speichert unter anderem Informationen über die jeweiligen Parameter der Regionen die im Rundfunkempfänger 1 als Betriebsparameter eingestellt werden müssen, um einen Empfang von Rundfunksendem in den einzelnen Regionen sicher zu stellen. In der Regionentabelle 7 sind die verschiedenen möglichen Regionen in denen sich der Rundfunkempfänger 1 befinden kann abgespeichert. Diese Regionen-Informationen können insbesondere geographische Koordinaten sein, welche die Ausdehnung einer Region mit gleichbleibenden Betriebsparametern, definieren.

Anhand dieser Informationen in der Regionentabelle 7 kann der Rundfunkempfänger 1 mittels der vom GPS-Gerät 5 gelieferten Positionsdaten durch Vergleich in der Korrelationseinheit 8 die momentane Region des Rundfunkempfängers 1 und somit den jeweiligen Ländercode bestimmen. Der Ländercode kann dann zur Konfiguration des Rundfunkempfängers 1 mit den entsprechenden Betriebsparametern, die ebenfalls im Speicher 3 abgelegt sind, verwendet werden.

Ein typisches Bordnetz 6, das in Fahrzeugen eingesetzt wird und welches das Navigationsgerät 4 mit dem Rundfunkempfänger 1 verbindet, ist beispielsweise das Media Oriented Systems Transport (MOST)-Netzwerk.

Mit den in Fig. 1 dargestellten Systemen ist es in Fahrzeugen möglich, Positionsdaten eines positionsbestimmenden Gerätes, wie eines GPS-Gerätes 5, auch in anderen Systemelementen, wie einem Rundfunkempfänger 1 zu nutzen. Die von der GPS-Einheit 5 bestimmten Positionsdaten können über das Datennetz 6 an den Rundfunkempfänger 1 weitergegeben werden. Eine im Rundfunkempfänger 1 integrierte Kommunikationseinheit (nicht in der Figur dargestellt) nimmt die Daten in Empfang und leitet sie an den Mikroprozessor 2 weiter.

Der Rundfunkempfänger 1 kann unter Zurhilfenahme des Mikroprozessors 2 und der Korrelationseinheit 8 die ihm übergebenen Positionsdaten speichern und auswerten und so dynamisch einen Ländercode entsprechend der Positionsdaten bestimmen. Dieser Ländercode kann dann in einem Speicher 3 im Rundfunkempfänger abgelegt, d.h. gespeichert, werden, um ihn bei dem erneuten Einschalten des Rundfunkempfängers 1 zur Konfiguration des Rundfunkempfängers 1 und seiner Betriebsparameter zur Verfügung zu haben.

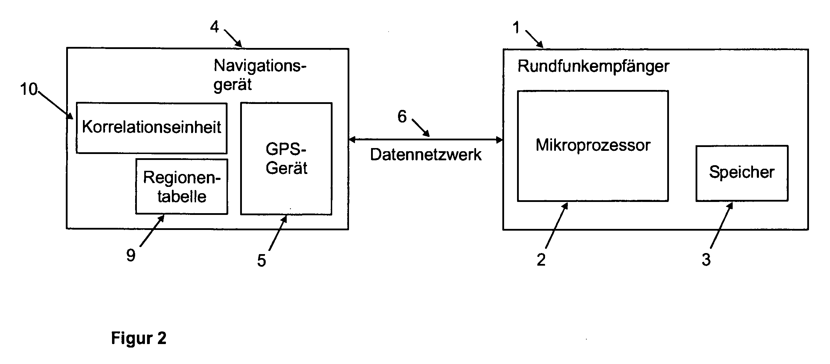

Fig. 2 zeigt eine zweite alternative Ausführungsform eines Rundfunkempfängers 1. In dieser Aufrührungsform besitzt die Navigationseinheit 4 neben dem GPS-Empfänger 5 eine Regionentabelle 9 und eine Korrelationseinheit 10. Mittels der Korrelationseinheit 10 kann auch eine positionsbestimmende Einheit, wie z.B. der GPS-Empfänger 5, den Ländercode wie oben beschrieben bestimmen und ihn an den Rundfunkempfänger 1 weiterleiten. Dies hat unter anderem den Vorteil, dass in dem GPS-Empfänger 5 die Regionentabelle 9, in der die einzelnen Regionen mit ihren geographischen Koordinaten definiert sind, dynamisch aktualisiert werden kann.

Insbesondere sind die eben beschriebenen Verfahrensweisen zur Bestimmung des Ländercodes bei der Initialisierung, d.h. beim ersten Einschalten eines Rundfunkgerätes 1 von Vorteil, da es dadurch nicht notwendig ist, während der Fertigung des Rundfunkempfängers 1 einen Ländercode fest im Speicher 3 des Rundfunkempfängers 1 im Produktionsprozess zu programmieren. Wie eben beschrieben, kann anhand von Positionsdaten der Ländercode entweder direkt im Rundfunkempfänger 1 oder in dem GPS-Empfänger 5 bestimmt und im Rundfunkempfänger 1 gespeichert werden und so das Gerät in jeder Region der Erde benutzt werden, ohne vorher bei der Produktion der Rundfunkempfänger einen entsprechenden Ländercode einzustellen.

In den in Figuren 1 und 2 gezeigten Ausführungsbeispielen eines Rundfunkempfängers 1 und dessen Kopplung an eine positionsbestimmende Einheit, wie z.B. das dargestellte GPS-Gerät 5, ist das GPS-Gerät 5 in einem Navigationsgerät 4 integriert dargestellt. Es ist jedoch auch möglich, unabhängig von anderen Komponenten ein GPS-Gerät zur Verfügung zu stellen, das nicht in andere Systemkomponenten integriert ist. Insbesondere wird dadurch die Nutzung des GPS-Geräts 5 und dessen Informationen durch andere Systemkomponenten, wie beispielsweise ein Rundfunkempfänger 1 erleichtert. Entsprechend können in der Ausführungsform entsprechend Fig. 2 die Regionentabelle 9 sowie die Korrelationseinheit 10 ebenfalls unabhängig vom Navigationsgerät 4 zur Verfügung gestellt werden.

Die vorliegende Erfindung ist gleichermaßen in digitalen und analogen Rundfunkempfängem einsetzbar. Bei dem Rundfunkempfängern kann es sich dabei um Empfänger zum Empfang von Fernseh- und/oder Radioprogrammen handeln. Weiterhin ist es ebenfalls denkbar, die von dem GPS-Gerät 5 empfangenen Positionsdaten im Rundfunkempfänger 1 zur Erfüllung oder Verbesserung der Funktionalität des Rundfunkempfängers 1 zu speichern.

Beim Empfang von Femsehsignalen ist es entsprechend der durch das GPS-Gerät 5 bestimmten Position möglich, das entsprechende Fernsehsystem für den Empfang der Fernsehsignale zu wählen, bzw. die Betriebsparameter des Rundfunkempfängers 1 für den Empfang von Femsehsignalen entsprechend seiner geografischen Position einzustellen. Die heutzutage verwendeten Fernsehsysteme wie PAL, NTSC und SECAM besitzen unterschiedliche Betriebsparameter, die im Rundfunkempfänger eingestellt werden müssen um Bild und Ton aus den übertragenen Signalen wiederherstellen zu können. Beispielsweise unterscheiden sich die verschiedenen Systeme im Modulationstyp des Tonträgers, dem Bild/Ton Abstand im Fernsehsignal und in der unterschiedlichen Kanalbreite und Videobandbreite der Signale. Da diese Parameter in den einzelnen Ländern typischerweise einheitlich sind, lässt sich die aktuelle, durch ein GPS Gerät 5 bestimmte Position des Rundfunkempfängers 1, auch vorteilhaft zur Parametrierung des Empfängers zum Empfang von Fernsehsignalen nutzen.

## Patentansprüche

1. Verfahren zur Konfiguration eines mobilen Rundfunkempfängers (1), der mit einer positionsbestimmenden Einheit (5) verbindbar ist, wobei das Verfahren die folgenden Schritte beinhaltet:
Bestimmen von Positionsdaten des Rundfunkempfängers (1) durch die positionsbestimmende Einheit (5),
Empfang der bestimmten Positionsdaten in dem Rundfunkempfänger (1),
Bestimmung eines Ländercodes basierend auf den empfangenen Positionsdaten und
Nicht-flüchtige Speicherung des Ländercodes in dem Rundfunkempfänger (1) in einem Speicher (3).

2. Verfahren nach Anspruch 1, weiterhin den Schritt des Einstellens von Betriebsparametern des Rundfunkempfängers (1) anhand des Ländercodes beinhaltend.

3. Verfahren nach Anspruch 1 oder 2, weiterhin den Schritt des Anforderns der Positionsdaten durch den Rundfunkempfänger (1) an die positionsbestimmende Einheit (5) beinhaltend.

4. Verfahren nach einem der Ansprüche 1 bis 3, wobei die positionsbestimmende Einheit (5) ein GPS Empfänger ist.

5. Verfahren nach einem der Ansprüche 1 bis 3, wobei die positionsbestimmende Einheit (5) ein Navigationsgerät ist, welches einen GPS Empfänger aufweist.

6. Verfahren nach einem der Ansprüche 1 bis 5, wobei der Speicher (3) ein EEPROM ist.

7. Verfahren nach einem der Ansprüche 3 bis 6, wobei der Schritt des Anfordems der Positionsdaten während der Initialisierung des Rundfunkempfängers (1) ausgeführt wird.

8. Verfahren nach Anspruch 2, wobei die Betriebsparameter einen oder mehrere der folgenden Parameter umfassen: Bandgrenzen der AM Bänder, Bandgrenzen der FM Bänder, Frequenzabstand zwischen zwei Rundfunksendem, AM-Bandbreite und die FM Nachentzerrung.

9. Verfahren nach Anspruch 2 oder 8, wobei die Betriebsparameter die notwendigen Parameter zur Wiedergabe von Fernsehsignalen entsprechend dem PAL, SECAM und/oder NTSC System umfassen.

10. Mobiler Rundfunkempfänger, der mit einer positionsbestimmenden Einheit (5) verbindbar ist, wobei der Rundfunkempfänger (1) beinhaltet:
eine Kommunikationseinheit zum Empfang von Positionsdaten, die von der positionsbestimmenden Einheit (5) ermittelt wurden,
einen Mikroprozessor (2) zum Bestimmung eines Ländercodes basierend auf den empfangenen Positionsdaten und
einen Speicher (3) zur nicht-flüchtigen Speicherung des Ländercodes in dem Rundfunkempfänger (1).

11. Rundfunkempfänger (1) nach Anspruch 10, wobei der Mikroprozessor (2) Betriebsparameter des Rundfunkempfängers (1) anhand des Ländercodes einstellt.

12. Rundfunkempfänger nach Anspruch 10 oder 11, wobei die Kommunikationseinheit die Positionsdaten von der positionsbestimmenden Einheit (5) anfordert.

13. Rundfunkempfänger nach einem der Ansprüche 10 bis 12, wobei die positionsbestimmende Einheit (5) ein GPS Empfänger ist.

14. Rundfunkempfänger nach einem der Ansprüche 10 bis 12, wobei die positionsbestimmende Einheit (5) ein Navigationsgerät ist, welches einen GPS Empfänger aufweist.

15. Rundfunkempfänger nach einem der Ansprüche 10 bis 14, wobei der Speicher (3) ein EEPROM ist.

16. Rundfunkempfänger nach einem der Ansprüche 12 bis 15, wobei der Mikroprozessor (2) während der Initialisierung des Rundfunkempfängers (1) die Positionsdaten mittels der Kommunikationseinheit anfordert.

17. Rundfunkempfänger nach Anspruch 10, wobei die Betriebsparameter einen oder mehrere der folgenden Parameter umfassen: Bandgrenzen der AM Bänder, Bandgrenzen der FM Bänder, Frequenzabstand zwischen zwei Rundfunksendern, AM-Bandbreite und die FM-Nachentzerrung.

18. Rundfunkempfänger nach Anspruch 10 oder 17, wobei die Betriebsparameter die notwendigen Parameter zur Wiedergabe von Fernsehsignalen entsprechend dem PAL, SECAM und/oder NTSC System umfassen.

19. Rundfunkempfänger nach einem der Ansprüche 10 bis 18, wobei der Rundfunkempfänger (1) ein mobiler Empfänger von Fernseh- und/oder Radioprogrammen ist.

20. Verfahren zur Konfiguration eines mobilen Rundfunkempfängers (1), der mit einer positionsbestimmenden Einheit (5) verbindbar ist, wobei das Verfahren die folgenden Schritte beinhaltet:
Bestimmen von Positionsdaten des Rundfunkempfängers (1) durch die positionsbestimmende Einheit (5),
Bestimmung eines Ländercodes basierend auf den empfangenen Positionsdaten und
Empfang des Ländercodes in dem Rundfunkempfänger (1),
Nicht-flüchtige Speicherung des Ländercodes in dem Rundfunkempfänger (1) in einem Speicher (3).

21. Verfahren nach Anspruch 20, weiterhin den Schritt des Einstellens von Betriebsparametern des Rundfunkempfängers (1) anhand des Ländercodes beinhaltend.

22. Verfahren nach Anspruch 20 oder 21, weiterhin den Schritt des Anfordems des Ländercodes durch den Rundfunkempfänger (1) an die positionsbestimmende Einheit (5) beinhaltend.

23. Verfahren nach Anspruch 22, wobei der Schritt des Anfordems des Ländercodes während der Initialisierung des Rundfunkempfängers (1) ausgeführt wird.

24. Mobiler Rundfunkempfänger, der mit einer positionsbestimmenden Einheit (5) verbindbar ist, wobei der Rundfunkempfänger (1) beinhaltet:
eine Kommunikationseinheit zum Empfang von einem Ländercode, der von der positionsbestimmenden Einheit (5) ermittelt wurde,
einen Mikroprozessor (2) zur Einstellung von Betriebsparametern des Rundfunkempfängers (1) anhand des Ländercodes und
einen Speicher (3) zur nicht-flüchtigen Speicherung des Ländercodes in dem Rundfunkempfänger (1).

25. Rundfunkempfänger nach Anspruch 24, wobei die Kommunikationseinheit den Ländercode von der positionsbestimmenden Einheit (5) anfordert.

26. Rundfunkempfänger nach einem der Ansprüche 24 bis 25, wobei der Mikroprozessor (2) während der Initialisierung des Rundfunkempfängers (1) den Ländercode mittels der Kommunikationseinheit anfordert.

27. Rundfunkempfänger nach einem der Ansprüche 24 bis 26, wobei der Rundfunkempfänger (1) ein mobiler Empfänger von Fernseh- und/oder Radioprogrammen ist.
